(19) Europäisches Patentamt
European Patent Office
Office européen des brevets

(11) **EP 0 849 604 A1**

(12) **EUROPÄISCHE PATENTANMELDUNG**

(43) Veröffentlichungstag:
24.06.1998 Patentblatt 1998/26

(51) Int. Cl.⁶: **G01R 31/36**

(21) Anmeldenummer: 97122251.8

(22) Anmeldetag: 17.12.1997

(84) Benannte Vertragsstaaten:
**AT BE CH DE DK ES FI FR GB GR IE IT LI LU MC NL PT SE**
Benannte Erstreckungsstaaten:
**AL LT LV MK RO SI**

(30) Priorität: 21.12.1996 DE 19653913

(71) Anmelder: **Schenck Process GmbH**
**64293 Darmstadt (DE)**

(72) Erfinder:
• **Zöller, Rolf**
**64293 Darmstadt (DE)**
• **Volk, Albert**
**63110 Rodgau (DE)**

(74) Vertreter: **Behrens, Helmut**
**Im Tiefen See 45 a**
**64293 Darmstadt (DE)**

(54) **Verfahren zur Feststellung von Schäden an Rotoren von Asynchronmaschinen und Vorrichtung zur Durchführung des Verfahrens**

(57)     Durch die Erfindung werden ein Verfahren und eine Vorrichtung zur Feststellung von Schäden an Rotoren von Asynchronmaschinen durch Bewertung und Analyse eines Seitenbandes im Frequenzspektrum des Motorstroms vorgeschlagen, die auch unter Industriebedingungen durchführbar bzw. einsetzbar sind und nicht auf Labormeßtechnik angewiesen sind. Von dem von der Asynchronmaschine aufgenommenen Motorstrom wird eine gleichphasige Sinusschwingung von 50 Hz subtrahiert und das so erhaltene, ein im Frequenzspektrum des Motorstromes unterhalb der 50 Hz-Grundfrequenz liegendes Seitenband repräsentierendes Meßsignal einer Bewertung zugeführt.

FIG. 1

EP 0 849 604 A1

## Beschreibung

Die Erfindung bezieht sich auf ein Verfahren zur Feststellung von Schäden an Rotoren von Asynchronmaschinen durch Bewertung eines Seitenbandes im Frequenzspektrum des Motorstromes und eine Vorrichtung zur Durchführung des Verfahrens.

Betrachtet man das Frequenzspektrum des Stromes einer als Motor betriebenen Asynchronmaschine, so ist in einem geringen Abstand zur 50 Hz-Grundkomponente bei der Frequenz

$$f_{sb} = f_n \, (1 - 2s)$$

eine Spektrallinie zu erkennen, deren Amplitude ein Maß für die Güte bzw. die Fehlerfreiheit des Rotors darstellt. Dabei ist $f_n$ die Netzfrequenz und $s$ der Schlupf, der aus der Drehfeld- oder Leerlaufdrehzahl $n_o$ und der tatsächlichen Rotordrehzahl $n_m$ nach der Gleichung errechnet wird:

$$s = \frac{n_o - n_m}{n_o}$$

Bei intaktem Rotor ist das Amplitudenverhältnis besagter Spektrallinie zur 50 Hz-Komponente ca. -60 dB. Die Frequenz, bei der sich diese Spektrallinie befindet, ist, wie obigen Gleichungen zu entnehmen ist, abhängig von der tatsächlichen Rotordrehzahl $n_m$ bzw. vom Schlupf $s$, und liegt zwischen 40 Hz und 50 Hz.

Den Nachweis von Schäden am Rotor, insbesondere von Stabbrüchen, durch Analyse dieses Seitenbandes zu führen, ist an sich bekannt. Es ist dies bisher jedoch nur mit einer Meßtechnik mit erhöhten Anforderungen, die Laborbedingungen genügen, möglich, weil die Stromamplitude der Seitenbandfrequenz, wie schon erwähnt, gegenüber der der Grundfrequenz, da die Stromamplitude des Seitenbandes ca. 1000 mal kleiner (-60 dB) als die der Grundfrequenz ist und in unmittelbarer Nähe, nur 0,5 bis 10 Hz neben der Grundfrequenz von 50 Hz liegt. Handelsübliche Maschinendiagnosegeräte sind auf eine Dynamik von ca. 50 dB beschränkt, so daß mit ihnen aus diesem Seitenband ablesbare Schadenssymptome nicht erkannt werden können.

Aufgabe der Erfindung ist es, ein Verfahren aufzuzeigen, mit dem in besagtem Seitenband auftretende Symptome oder Abweichungen auch unter Industriebedingungen zur Feststellung von Schäden am Rotor von Asynchronmaschinen genutzt werden können, und eine Schaltung zur Durchführung dieses Verfahrens zu schaffen, die geeignet ist, in einem mobilen Prüfgerät unter Industriebedingungen eingesetzt zu werden. Dabei soll ein solches Prüfgerät preisgünstig und einfach in der Bedienung sein.

Erfindungsgemäß wird dies dadurch erreicht, daß von dem von der Asynchronmaschine aufgenommenen Motorstrom eine gleichphasige Sinusschwingung von 50 Hz subtrahiert und das so erhaltene, ein im Frequenzspektrum des Motorstromes unterhalb der 50 Hz-Komponente liegendes Seitenband und die Amplitude der Grundfrequenz einer Bewertung zugeführt wird. Indem die 50 Hz-Komponente des Motorstromes auf diese Weise unterdrückt wird, kann das unterhalb von ihr liegende und für die Maschinendiagnose interessierende Seitenband hervorgehoben und dargestellt werden, ohne daß es labormäßiger Prüfgeräte bedarf.

Die vom Motorstrom zu subtrahierende Sinusschwingung wird vorzugsweise mittels eines Bandpaßfilters mit einer Resonanzfrequenz von 50 Hz direkt aus dem Netzstrom erzeugt. So wird auf einfache Weise erreicht, daß die Sinusschwingung mit der 50 Hz-Komponente des Motorstroms gleichphasig ist und die Subtraktion tatsächlich zu einer Unterdrückung dieser 50 Hz-Komponente führt.

Um ein im interessierenden Frequenzbereich von 40 Hz bis 50 Hz von Signalresten befreites Sinus ähnliches Signal zu erhalten, wird der vom Motor aufgenommene Netzstrom vorteilhaft zunächst in eine Rechteckspannung umgewandelt und diese einem Bandpaßfilter mit einer Resonanzfrequenz von 50 Hz zugeführt; die so am Ausgang des Bandpaßfilters entstehende Sinusschwingung kann dann in einem Subtrahierer vom Motorstromsignal subtrahiert und das Ausgangssignal des Subtrahierers zur Diagnose von Rotorschäden herangezogen werden.

In vorteilhafter Fortbildung der Erfindung wird die Amplitude der vom Motorstromsignal zu subtrahierenden Sinusschwingung entsprechend der Amplitude der 50 HZ-Komponente des Motorstroms als Führungsgröße geregelt. So wird erreicht, daß die 50 Hz-Komponente des Motorstroms bei der Subtraktion gleichmäßig unterdrückt bzw. gedämpft wird.

Für die Regelung der Amplitude werden nach der Erfindung sowohl die erzeugte Sinusschwingung als auch das die Nutzinformation tragende Motorstromsignal in eine der Signalgröße entsprechende Gleichspannung umgewandelt. Die der Sinusschwingung entsprechende Gleichspannung wird als Regelgröße mit der aus dem Motorstromsignal gewonnenen Gleichspannung als Führungsgröße im Regler eines Regelkreises zur Erzeugung einer die Amplitude der Sinusschwingung nachstellenden Stellgröße verglichen.

Eine erfindungsgemäße Vorrichtung zur Durchführung des beschriebenen Verfahrens weist eine Filterschaltung auf, durch die aus dem vom Motor aufgenommenen Netzstrom eine mit diesem gleichphasige Sinusschwingung von 50 Hz erzeugt und vom Motorstromsignal subtrahiert wird.

Vorzugsweise enthält die Filterschaltung einen Komparator, der aus dem vom Motor aufgenommenen Netzstrom eine phasenstarre Rechteckspannung erzeugt. Dem Komparator ist ein 50 Hz-Bandpaßfilter nachgeschaltet, dessen sinusförmiges Ausgangssignal an dem einen Eingang eines Subtrahierers angelegt ist, während am anderen Eingang dieses Subtrahierers das Motorstromsignal anliegt. Zur Subtraktion sind diese beiden Signale einander gegengeschaltet, so daß am Ausgang des Subtrahierers ein dem Motorstrom mit unterdrückter 50 Hz-Komponente entsprechendes Meßsignal abgenommen werden kann.

Zur Regelung der Amplitude des sinusförmigen Ausgangssignals des 50 Hz-Bandpaßfilters wird dieses Ausgangssignal einem Gleichrichter zugeführt und so eine diesem sinusförmigen Ausgangssignal proportionale Gleichspannung erzeugt, die als Regelgröße an dem einen Eingang eines PI-Reglers angelegt wird, während an dem anderen Eingang dieses PI-Reglers eine der Amplitude der 50 Hz-Komponente des Motorstromsignals proportionale Gleichspannung als Führungsgröße ansteht.

Zwischen dem Ausgang des genannten Gleichrichters und dem betreffenden Eingang des PI-Reglers ist vorzugsweise ein die Ausgangsspannung dieses Gleichrichters integrierendes, d.h. glättendes PT1-Glied eingeschaltet. Dies dient der Mittelwertbildung des Gleichrichterausgangssignals und der Beruhigung der Reglerausgangsgröße.

Zur Erzeugung der Führungsgröße des Regelkreises wird vorteilhaft die 50 Hz-Komponente des Motorstromsignals herangezogen. Dazu ist das Motorstromsignal auch am Eingang eines zweiten 50 Hz-Bandpaßfilters angelegt und dessen Ausgang ist mit einem Spitzenwertgleichrichter verbunden.

Vor jeder Messung kann der den Scheitelwert der 50 Hz-Komponente des Motorstromsignals speichernde Kondensator des Spitzenwertgleichrichters mit Hilfe eines Tasters manuell entladen werden.

Dem Komparator und dem ersten 50 Hz-Bandpaßfilter kann ein Abschwächer mit einem Steuereingang als Stellglied des Regelkreises zwischengeschaltet sein. Die von der Differenz zwischen Führungsgröße und Regelgröße abhängige Ausgangsgröße des PI-Reglers wird dann an diesen Steuereingang angelegt.

In einer vorteilhaften Anwendung der Erfindung wird die beschriebene Filterschaltung einer den Motorstrom aufnehmenden Stromprüfzange und einem handelsüblichen Maschinendiagnosegerät zwischengeschaltet.

Die Erfindung ist preisgünstig und ohne großen Aufwand zu realisieren und erlaubt es, auch unter Industriebedingungen Schäden an Rotoren von Asynchronmaschinen durch die Analyse des Seitenbandes im Frequenzspektrum festzustellen, was bisher nur mit Labormeßtechnik möglich war.

Die Erfindung wird nachfolgend anhand eines Ausführungsbeispiels näher erläutert, das in der Zeichnung dargestellt ist. Es zeigen

Fig. 1     ein Blockschaltbild einer in einem erfindungsgemäßen Gerät verwendbaren Schaltung,

Fig. 2a     in einem Diagramm den normalen, also nicht wie nach der Erfindung beeinflußten Verlauf des Motorstroms einer Asynchronmaschine über der Zeit,

Fig. 2b     das Frequenzspektrum des Motorstroms gemäß Figur 2a,

Fig. 3a     in einem Diagramm den Verlauf des Motorstroms einer Asynchronmaschine über der Zeit, wobei die 50 Hz-Komponente erfindungsgemäß unterdrückt bzw. bedämpft ist,

Fig. 3b     das Frequenzspektrum des Motorstroms gemäß Figur 3a,

Fig. 4     als Blockschaltbild einen Meßaufbau zur Bestimmung der Eigenschaften der erfindungsgemäßen Schaltung,

Fig. 5a     exemplarisch dargestellt eines in einem Meßaufbau nach Figur 4 verwendeten Meßsignals im interessierenden Frequenzbereich,

Fig. 5b     in einem Diagramm den Verlauf des Amplitudenverhältnisses der Ausgangsgröße der erfindungsgemäßen Schaltung zu ihrer Eingangsgröße im interessierenden Frequenzbereich in halblogarithmischer Darstellung,

Fig. 6     als Blockschaltbild eine Möglichkeit zur Realisierung des Meßaufbaus nach der Erfindung.

Die Schwierigkeiten bei der Auswertung des im Frequenzspektrum des Motorstroms unterhalb der Grundfrequenz von 50 Hz liegenden Seitenbandes zur Feststellung von Schäden, z.B. Stabbrüchen, am Rotor von Asynchronmaschinen ergeben sich daraus, daß die Seitenbandfrequenz, an der sich die zu bewertende Spektrallinie zeigt, nur 0,5 bis 10 Hz unterhalb der Grundfrequenz, nämlich zwischen 40 Hz und 49,5 Hz liegt und daß das Verhältnis der Amplitude dieser Spektrallinie des Motorstroms zu der bei der Grundfrequenz ca. -60 dB beträgt.

Um eine Auswertung des Seitenbandes vornehmen, bzw. die Amplitude der Spektrallinie $i_{sb}$ bewerten zu können, muß die Amplitude der 50 Hz-Komponente des Motorstroms um mindestens 20 dB oder mehr unterdrückt oder abgeschwächt werden, ohne das Seitenband merklich zu beeinflussen. Wegen des geringen Abstandes der Seitenbandfrequenz $f_{sb}$ von der Grundfrequenz $f_n$ kommt dazu die Verwendung einer normalen, steilflankigen, analogen Filterschaltung nicht in Frage, da dies eine sehr hohe Güte und / oder Filterordnung erfordern würde.

Die Erfindung macht sich die Tatsache zunutze, daß die Substraktion zweier gleichphasiger Signale mit gleicher Amplitude Null ergibt. Um die 50 Hz-Komponente des Motorstroms in dem gewünschten Maß zu bedämpfen, soll also eine weitere gleichphasige Sinusschwingung von 50 Hz erzeugt und von der Motorstrom-Schwingung subtrahiert werden. Um das Seitenband, das für die Diagnose des Rotors bewertet werden soll, dabei nicht oder zumindest nicht nennenswert zu beeinflussen, muß diese zusätzliche Sinusschwingung in dem interessierenden Frequenzbereich von ca. 40 Hz bis 49,5 Hz außerdem möglichst frei von anderen spektralen Anteilen sein.

Die Phasengleichheit beider Schwingungen wird erreicht, indem die zusätzliche Sinusschwingung direkt aus dem Netzstrom gewonnen wird. Um letztere von dem die Nutzinformation tragenden Signalanteil zu befreien, wird der vom Motor aufgenommene Strom zunächst in eine Rechteckspannung umgewandelt und aus dieser dann mit Hilfe eines Bandpasses mit einer Resonanzfrequenz von $f_{res}$ = 50 Hz eine sinusähnliche Spannung erzeugt, die in dem Fequenzbereich nahe bei 50 Hz keinerlei Signalreste aufweist und somit zur Auslöschung oder zumindest Bedämpfung der 50 Hz-Komponente im Meßsignal benutzt werden kann.

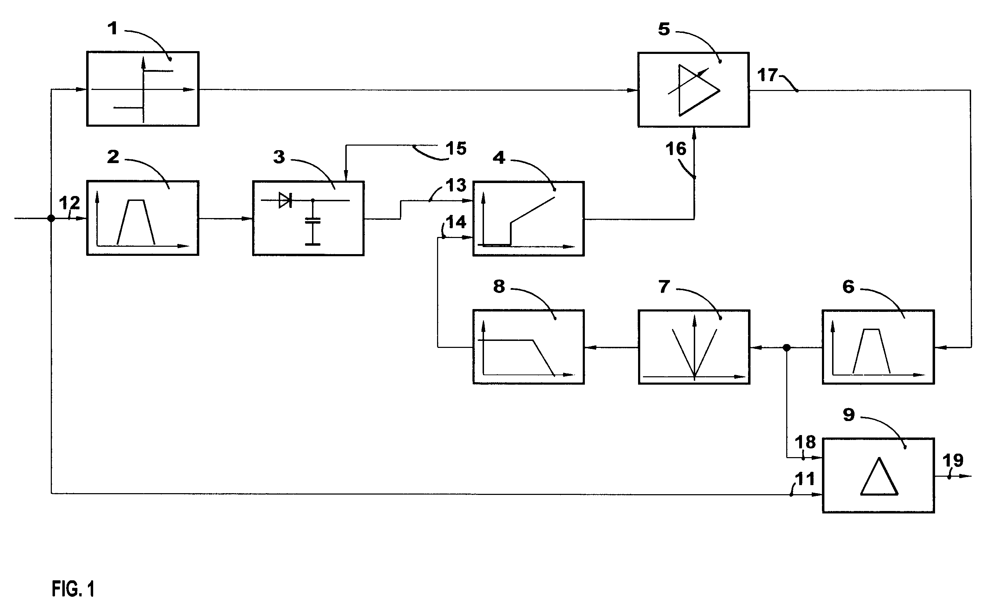

Figur 1 zeigt das Blockschaltbild einer erfindungsgemäßen Schaltung. Der vom Motor aufgenommene Strom wird zum einen dem einen Eingang 11 eines Subtrahierers 9 und außerdem einem Komparator 1 zugeführt, der daraus eine phasenstarre Rechteckspannung erzeugt. Dem Komparator 1 nachgeschaltet ist ein Abschwächer 5, der das Stellglied in einem weiter unten beschriebenen Regelkreis bildet und die Amplitude der Rechteckspannung entsprechend der Ausgangsspannung eines PI-Reglers 4, die als Stellgröße im Regelkreis dient, laufend nachstellt. Der Ausgang des Abschwächers 5 ist mit dem Eingang eines ersten 50 Hz-Bandpaßfilters 6 verbunden, der die ihm zugeführte Rechteckspannung in eine sinusförmige Wechselspannung von 50 Hz umwandelt. Das Bandpaßfilter 6 filtert also die Oberwellen aus dem Rechtecksignal und besitzt im Idealfall bei der Resonanzfrequenz von 50 Hz eine Phasendrehung von 0°. Die so entstandene Sinusschwingung enthält zwar in Wirklichkeit noch Oberwellen, sie ist aber von der Frequenzkomponente $f_{sb}$ befreit und mit dem ursprünglichen Signal des Motorstroms so gut wie phasengleich; sie ist somit geeignet, die 50 Hz-Komponente des Motorstroms, wie gefordert, zu unterdrücken. Die gewonnene Sinusschwingung wird also dem zweiten Eingang 18 des Subtrahierers 9 zugeführt und dem die Nutzinformation des Motorstroms tragenden Signal am ersten Eingang 11 des Subtrahierers 9 gegengeschaltet.

Damit die 50 Hz-Komponente des Motorstromsignals gleichmäßig unterdrückt bzw. gedämpft werden kann, muß die Amplitude der dazu erzeugten Sinusschwingung immer gleich der Amplitude der 50 Hz-Komponente des Motorstroms sein bzw. in einem gleichbleibenden Verhältnis zu ihr stehen. Zu diesem Zweck wird die aus dem Netzstrom erzeugte Sinusschwingung in ihrer Amplitude von einem PI-Regler 4 geregelt.

Die Ausgangsspannung des PI-Reglers 4, die als Stellgröße dem Steuereingang 16 des Abschwächers 5 zugeführt wird, ist abhängig von der Differenz zwischen einer Führungsgröße und einer aus der, wie oben gewonnenen Sinusschwingung abgeleiteten und deren Amplitude repräsentierenden Regelgröße, die beide dem PI-Regler 4 als Eingangsgrößen zum Vergleich zugeführt werden. Die Führungsgröße wird ebenfalls direkt aus dem die Nutzinformation tragenden Motorstromsignal gewonnen, indem dieses auch dem Eingang 12 eines zweiten 50 Hz-Bandpaßfilters 2 zugeführt wird, das nur die 50 Hz-Komponente des Motorstromsignals passieren läßt. Nur diese 50 Hz-Komponente wird zur Erzeugung der Führungsgröße herangezogen; sie bildet die Eingangsgröße eines Spitzenwertgleichrichters 3, der an seinem Ausgang die Führungsgröße für den Regelkreis in Form einer der Amplitude der 50 Hz-Komponente entsprechenden Gleichspannung bereitstellt, die an dem einen Eingang 13 des PI-Reglers 4 angelegt wird.

Der Kondensator des Spitzenwertgleichrichters 3, der den Scheitelwert der 50 Hz-Komponente des Motorstroms speichert, muß zu Beginn einer jeden Messung entladen werden. Dies kann, wie bei 15 angedeutet, manuell mit Hilfe eines Tasters geschehen.

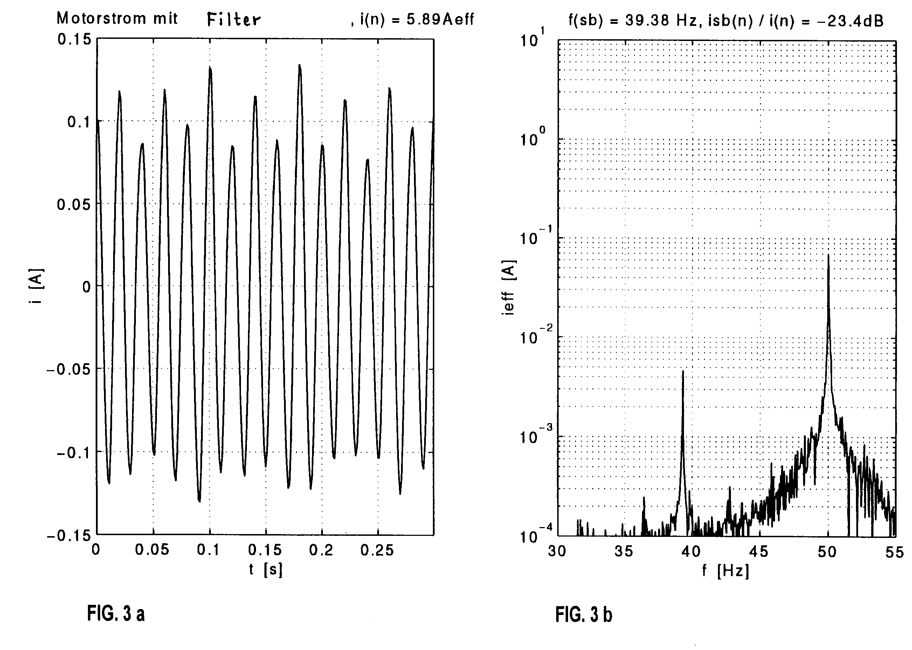

Zur Erzeugung der mit der Führungsgröße zu vergleichenden Regelgröße wird die am Ausgang des ersten 50 Hz-Bandpaßfilters 6 aus der Rechteckspannung erzeugte, sinusförmige Wechselspannung in einem Gleichrichter 7 in eine dem Betrag der Sinusspannung entsprechende pulsierende Gleichspannung und mit Hilfe des PT1-Gliedes 8 in eine dem Mittelwert des Betrages der Sinusspannung entsprechende Gleichspannung umgeformt. Die geglättete Ausgangsspannung des PT1-Gliedes 8 wird als Regelgröße dem zweiten Eingang 14 des PI-Reglers 4 zugeführt. Dieser vergleicht die Regelgröße mit der am Eingang 13 zugeführten Führungsgröße und erzeugt an seinem Ausgang ein von der Differenz abhängiges Steuersignal, das als Stellgröße am Steuereingang 16 des Abschwächers 5 angelegt wird, um die Amplitude der Rechteckspannung am Ausgang 17 des Abschwächers 5 entsprechend nachzustellen. Da, wie oben bereits erwähnt, die Führungsgröße am Eingang 13 des PI-Reglers 4 die Amplitude der 50 Hz-Komponente des Motorstroms repräsentiert, wird also die Rechteckspannung am Ausgang 17 des Abschwächers 5 laufend der Amplitude der 50 Hz-Komponente nachgestellt und es wird am Ausgang des dem Abschwächer 5 nachgeschalteten 50 Hz-Bandfilters 6 die 50 Hz-Sinusschwingung mit der der 50 Hz-Komponente des Motorstroms angepaßten Amplitude erzeugt, die benötigt wird, um die 50 Hz-Komponente des Motorstroms, wie gefordert, unterdrücken bzw. gleichmäßig dämpfen zu können. Am Ausgang 19 des Subtrahierers 9 erhält man dann ein Meßsignal, das dem Motorstrom mit unterdrückter 50 Hz-Komponente gemäß Figuren 3a und 3b entspricht und in dem somit das für die Diagnose an Rotoren von Asynchronmaschinen zu bewertende Seitenband im Frequenzspektrum gemäß Figur 3b hervorgehoben ist.

Bei der Auslegung der Bandpaßfilter 2 und 6 kommt es darauf an, möglichst nur die eine Frequenz von 50 Hz herauszufilgern. Als Bandpaßfilter können daher 50 Hz-Durchlaßfilter verwendet werden.

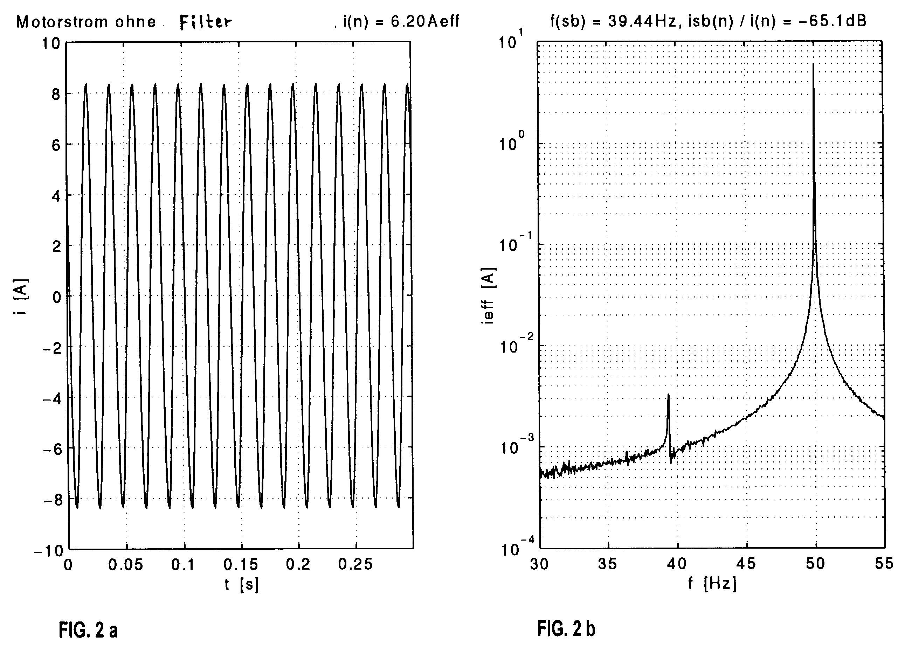

Das Ergebnis ist deutlich bei einem Vergleich der Figuren 2a und 2b mit den Figuren 3a und 3b zu erkennen. Die Figuren 2a und 2b zeigen den Verlauf des Motorstroms über der Zeit bzw. das Frequenzspektrum des Motorstroms ohne Filterung, also mit 50 Hz-Komponente. Dabei ist im Frequenzspektrum der Figur 2b die große Differenz zwischen der 50 Hz-Komponente und der Seitenbandkomponente bei $f_{sb}$ = 39,44 Hz gut sichtbar. Die Figuren 3a und 3b zeigen den Verlauf des Motorstroms über der Zeit und das Frequenzspektrum mit um ca. 40 dB gedämpfter 50 Hz-Komponente. Wegen der Offsetfehler im Regelkreis und einer ungewollt auftretenden Phasenverschiebung im 50 Hz-Bandpaßfilter 6 wird die 50 Hz-Komponente nicht vollständig unterdrückt, sondern es verbleibt ein geringer 50 Hz-Anteil im Nutzsignal. Für die Messung wurde der Motorstrom über die zuvor beschriebene Filterschaltung in eine 12 Bit AD-Wandlerkarte eingespeist.

Bei einer Messung mit einem handelsüblichen Maschinendiagnosegerät konnte die Seitenlinie ohne Filterung aufgrund der begrenzten Dynamik nicht dargestellt werden.

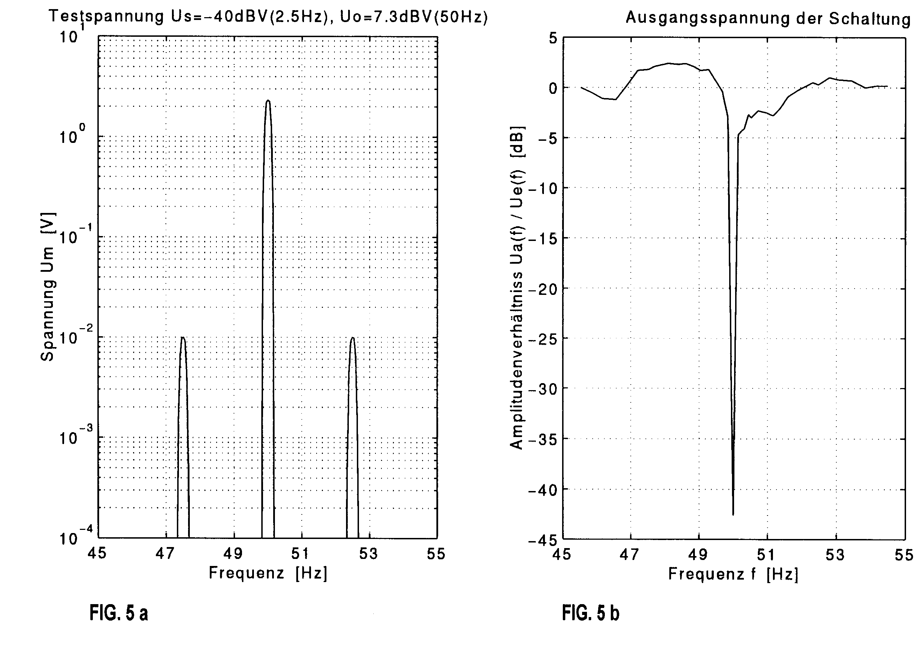

Die Eigenschaften der erfindungsgmäßen Filterschaltung wurden außerdem mit Hilfe eines AM-Signales untersucht. Figur 4 zeigt den dafür verwendeten Meßaufbau. Eine in einem Frequenzgenerator 20 erzeugte Trägerspannung von 7.3 dBV, d.h. ca. 2,3 $V_{eff}$, mit einer Frequenz von 50 Hz wurde mit einer von einem Sinusgenerator 21 erzeugten Spannung von -40dBV, d.h. ca. 10 mV, die von 0,2 Hz bis 4,5 Hz durchstimmbar war, moduliert und zum Vergleich einmal direkt und einmal über eine oben beschriebenen Filterschaltung 22 den Eingängen eines Spektrum-Analysators 23 zugeführt, in dem die Ausgangsspannung und die Eingangsspannung der Filterschaltung 22 zueinander ins Verhältnis gesetzt wurden. Es wurde die Ausgangsspannung der Meßschaltung punktweise für verschiedene Signalfrequenzen aufgenommen.

Figur 5a zeigt exemplarisch das Frequenzspektrum eines im Test verwendeten Meßsignals, es wurde für den betreffenden Frequenzbereich einem realen Asynchronmotor mit einem defekten Stab nachempfunden; zu sehen sind die 50 Hz-Spektrallinie und zwei Seitenlinien.

Figur 5b gibt den Verlauf des Amplitudenverhältnisses der Ausgangsspannung U*a (f)* zur Eingangsspannung Ue*(f)* der beschriebenen Filterschaltung 22 in halblogarithmischer Darstellung wieder. Deutlich ist die Unterdrückung der 50 Hz-Komponente um ca. -40 dB sichtbar. Die daneben im Durchlaßbereich erkennbaren Unruhen von nur 2dB sind wahrscheinlich auf ungünstige Meßbedingungen zurückzuführen; sie beeinträchtigen die Verwertbarkeit des gewonnenen Meßsignals für die Feststellung von Rotorschäden nicht. Es handelt sich bei der dargestellten Grafik nicht um einen Frequenzgang, da die Schaltung nichtlinear und die Ausgangsgröße von mehreren Faktoren, z.B. der Aussteuerung abhängig ist.

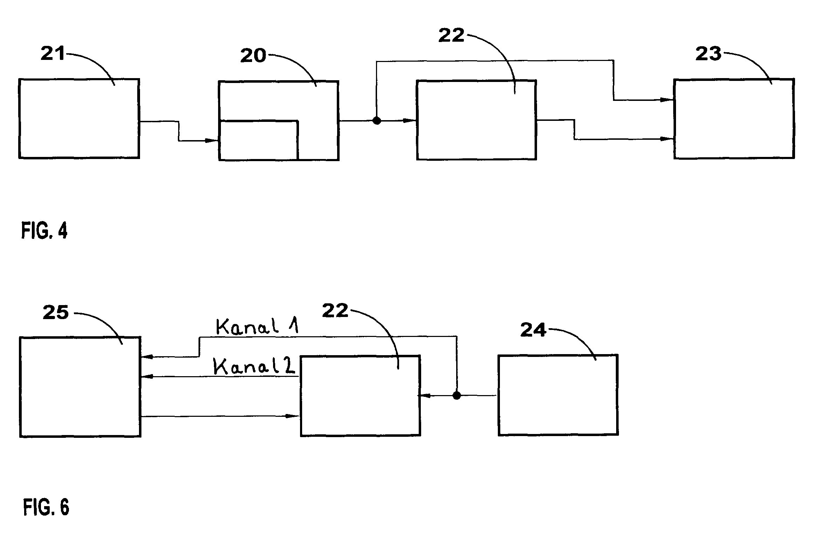

In Figur 6 ist schematisch eine Möglichkeit zur Realisierung des Meßaufbaus dargestellt. Die beschriebene Filterschaltung 22 kann in einer kleinen Box untergebracht und mit der durch ein handelsübliches Maschinendiagnosegerät 25 (z.B. VIBROPORT 41) zur Verfügung gestellten Aufnehmerversorgung gespeist werden. Als Aufnehmer kann eine handelsübliche Stromzange Verwendung finden, die eine potentialfreie Messung ermöglicht und so auch das problemlose Überprüfen von Hochspannungsmotoren erlaubt. Der von der Stromzange 24 aufgenommene Motorstrom wird einmal ungefiltert über den Kanal 1 und außerdem über den Kanal 2 mit durch die Filterschaltung 22 unterdrückter 50 Hz-Komponente an das Diagnosegerät 25 angelegt.

Bei der Messung an Motoren stellte sich heraus, daß eine Vielzahl von unterschiedlichen Frequenzen im Motorstrom vorhanden sind, die bis zu mehreren kHz reichen. Diese werden vorwiegend von den stromdurchflossenen, im Magnetfeld rotierenden Stäben verursacht und sind somit abhängig von der Drehzahl. Die Überlagerung von mehreren Frequenzen hat nun wiederum zur Folge, daß die Nulldurchgänge des Motorstromes nicht mehr exakt alle 20 ms stattfinden, sondern, wenn auch nur geringfügig, von 20 ms abweichen. Der Komparator 1 der Filterschaltung gemäß Figur 1 wirkt nun seinerseits wie ein aus der Nachrichtentechnik bekannter Phasendemodulator und erzeugt im Bereich um die 50 Hz-Spektrallinie neue Frequenzen, die eine drehzahlabhängige Lage aufweisen und bei

$$f_{pm} = (n_o - n_m) \cdot N_2 \cdot k + l \cdot f_n$$

angesiedelt sind, wobei $N_2$ die Stabanzahl des Rotors und k ungerade ganzzahlige und gerade ganzzahlige Faktoren 0, ±1, ±2,... sind und l ungerade ganzzahlige Faktoren ±1, ±3, ±5,... sind.

Diese neuen Frequenzen können bei Motoren mit großem Schlupf unter Umständen Probleme bereiten. In seltenen Ausnahmefällen kann es zur Überlagerung mit dem Nutzsignal kommen. Dies läßt sich aber auf einfache Weise feststellen. Durch eine kleine Änderung der Drehzahl läßt sich das Problem beheben, da sich diese störenden Frequenzen $f_{pm}$ mit dem Faktor $N_2$ ändern. Eine typische Stabanzahl ist z.B. $N_2$ = 28.

Es können auch weitere Bandpaßfilter zur Unterdrückung der Störfrequenzen $f_{pm}$ in die Filterschaltung eingebaut werden. Der Phasengang der Resonanzfrequenz wird dann allerdings sehr steil und es müssen neue Abgleichpunkte in die Schaltung aufgenommen werden.

Im Interesse eines einfachen und kostengünstigen Aufbaus des Gerätes wird daher eher auf zusätzliche Bandpaßfilter verzichtet, zumal die Probleme, wie erwähnt, nur sehr selten auftreten und dann leicht behebbar sind. Bei ansonsten problemlos durchgeführten Testmessungen kam es nur an zwei Meßpunkten von insgesamt ca. 200, bei einem Motor mit einem großen Schlupf, zu einer Überlagerungserscheinung.

Bei einem Vergleich der mit der erfindungsgemäßen Filterschaltung erhaltenen Meßreihen mit denen, die mit einem hochauflösenden Spektrumanalyzer unter Laborbedingungen (z.B. der Betriebsart ZOOM-FFT) gemacht wurden, konnte eine sehr gute Übereinstimmung festgestellt werden.

Eine noch bessere Unterdrückung der 50 Hz-Grundschwingung des Motorstroms kann durch den Einsatz hochwertiger Operationsverstärker und optimierter Schaltungstechnik erreicht werden; sie ist aber nicht unbedingt erforderlich.

**Patentansprüche**

1. Verfahren zur Feststellung von Schäden an Rotoren von Asynchronmaschinen durch Bewertung und Analyse eines Seitenbandes im Frequenzspektrum des Motorstromes, **dadurch gekennzeichnet, daß** von dem von der Asynchronmaschine aufgenommenen Motorstrom eine gleichphasige Sinusschwingung von 50 Hz subtrahiert und das so erhaltene, ein im Frequenzspektrum des Motorstromes unterhalb der 50 Hz-Komponente liegendes Seitenband repräsentierendes Meßsignal einer Bewertung zugeführt wird.

2. Verfahren nach Anspruch 1, dadurch gekennzeichnet, daß die vom Motorstrom zu subtrahierende, mit ihm gleichphasige Sinusschwingung mittels eines Bandpaßfilters (6) mit einer Resonanzfrequenz von 50 Hz direkt aus dem Netzstrom erzeugt wird.

3. Verfahren nach Anspruch 1 oder 2, dadurch gekennzeichnet, daß der vom Motor aufgenommene Netzstrom in eine Rechteckspannung umgewandelt wird, welche einem Bandpaßfilter (6) mit einer Resonanzfrequenz von 50 Hz zugeführt wird, und daß die am Ausgang des Bandpaßfilters (6) entstehende Sinusschwingung in einem Subtrahierer (9) vom Motorstromsignal subtrahiert wird und das Ausgangssignal des Subtrahierers (9) zur Diagnose von Rotorschäden herangezogen wird.

4. Verfahren nach einem der Ansprüche 1 bis 3, dadurch gekennzeichnet, daß die Amplitude der vom Motorstromsignal zu subtrahierenden Sinusschwingung entsprechend der Amplitude der 50 HZ-Komponente des Motorstroms als Führungsgröße geregelt wird.

5. Verfahren nach Anspruch 4, dadurch gekennzeichnet, daß sowohl die erzeugte Sinusschwingung als auch das die Nutzinformation tragende Motorstromsignal in eine der Signalgröße entsprechende Gleichspannung umgewandelt werden, daß die der Sinusschwingung entsprechende Gleichspannung als Regelgröße und die aus dem Motorstromsignal gewonnene Gleichspannung als Führungsgröße im Regler eines Regelkreises zur Erzeugung einer die Amplitude der Sinusschwingung nachstellenden Stellgröße verglichen werden.

6. Vorrichtung zur Durchführung des Verfahrens nach einem der Ansprüche 1 bis 5, gekennzeichnet durch eine Filterschaltung (22), durch die aus dem vom Motor aufgenommenen Netzstrom eine mit diesem gleichphasige Sinusschwingung von 50 Hz erzeugbar und vom Motorstromsignal subtrahierbar ist.

7. Vorrichtung nach Anspruch 6, dadurch gekennzeichnet, daß die Filterschaltung (22) einen Komparator (1) enthält, durch den aus dem vom Motor aufgenommenen Netzstrom eine phasenstarre Rechteckspannung erzeugbar ist, daß diesem Komparator (1) ein 50 Hz-Bandpaßfilter (6) nachgeschaltet ist, dessen sinusförmiges Ausgangssignal an dem einen Eingang (18) eines Subtrahierers (9) angelegt ist, und daß am anderen Eingang (11) dieses Subtrahierers (9) das Motorstromsignal angelegt ist und diese beiden Signale einander gegengeschaltet sind und so am Ausgang (19) des Subtrahierers (9) ein dem Motorstrom mit unterdrückter 50 Hz-Komponente entsprechendes Meßsignal abnehmbar ist.

8. Vorrichtung nach Anspruch 7, dadurch gekennzeichnet, daß zur Regelung der Amplitude des sinusförmigen Ausgangssignals des 50 Hz-Bandpaßfilters (6) dieses Ausgangssignal an den Eingang eines Gleichrichters (7) angelegt ist zur Erzeugung einer diesem sinusförmigen Ausgangssignal proportionalen Gleichspannung, die die an dem einen Eingang (14) eines PI-Reglers (4) liegende Regelgröße ist, während an dem anderen Eingang (13) dieses PI-Reglers (4) eine der Amplitude der 50 Hz-Komponente des Motorstromsignals proportionale Gleichspannung als Führungsgröße angelegt ist.

9. Vorrichtung nach Anspruch 8, dadurch gekennzeichnet, daß zwischen dem Ausgang des Gleichrichters (7) und dem einen Eingang (14) des PI-Reglers (4) ein die Ausgangsspannung des Gleichrichters (7) integrierendes, d.h. glättendes PT1-
Glied (8) eingeschaltet ist.

10. Vorrichtung nach Anspruch 8 oder 9, dadurch
gekennzeichnet, daß das Motorstromsignal mit
dem Eingang (12) eines zweiten 50 Hz-Bandpaßfilters (2) verbunden ist und dessen Ausgang mit
einem Spitzenwertgleichrichter (3) zur Erzeugung
der Führungsgröße des Regelkreises verbunden
ist.

11. Vorrichtung nach Anspruch 10, dadurch gekennzeichnet, daß der den Scheitelwert der 50 Hz-Komponente des Motorstromsignals speichernde
Kondensator des Spitzenwertgleichrichters (3) mit
Hilfe eines Tasters (15) manuell entladbar ist.

12. Vorrichtung nach einem der Ansprüche 8 bis 11,
dadurch gekennzeichnet, daß dem Komparator (1)
und dem ersten 50 Hz-Bandpaßfilter (6) ein
Abschwächer (5) mit einem Steuereingang (16) als
Stellglied des Regelkreises zwischengeschaltet ist
und die von der Differenz zwischen Führungsgröße
und Regelgröße abhängige Ausgangsgröße des
PI-Reglers (4) an diesen Steuereingang (16) angelegt ist.

13. Vorrichtung nach einem der Ansprüche 6 bis 12,
dadurch gekennzeichnet, daß die Filterschaltung
(22) einer den Motorstrom aufnehmenden Stromprüfzange (24) und einem handelsüblichen Maschinendiagnosegerät (25) zwischengeschaltet ist.

FIG. 1

Motorstrom ohne Filter , i(n) = 6.20 Aeff

f(sb) = 39.44 Hz, isb(n) / i(n) = −65.1 dB

FIG. 2 a

FIG. 2 b

EP 0 849 604 A1

Motorstrom mit Filter , i(n) = 5.89Aeff

f(sb) = 39.38 Hz, isb(n) / i(n) = −23.4dB

FIG. 3 a

FIG. 3 b

**FIG. 5 b**

Ausgangsspannung der Schaltung

Amplitudenverhältniss Ua(f) / Ue(f) [dB]

Frequenz f [Hz]

**FIG. 5 a**

Testspannung Us=-40dBV(2.5Hz), Uo=7.3dBV(50Hz)

Spannung Um [V]

Frequenz [Hz]

11

FIG. 4

FIG. 6

**Europäisches Patentamt**

# EUROPÄISCHER RECHERCHENBERICHT

Nummer der Anmeldung

EP 97 12 2251

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | US 5 550 880 A (ABDEL-MALEK ET AL.)<br>* Abbildung 1 *<br>--- | 1,4,6,7 | G01R31/36 |
| X | US 5 550 879 A (HERSHEY)<br>* Abbildung 1 *<br>--- | 1,4,6,7 | |
| A | US 5 030 917 A (KLIMAN)<br>* Abbildung 1 *<br>--- | 1-13 | |
| A | US 5 049 815 A (KLIMAN)<br>* Abbildung 1 *<br>--- | 1-13 | |
| A | US 4 808 932 A (SCHULZ ET AL.)<br>* Abbildung 2 *<br>----- | 1-13 | |

**RECHERCHIERTE SACHGEBIETE (Int.Cl.6)**

G01R

Der vorliegende Recherchenbericht wurde für alle Patentansprüche erstellt

| Recherchenort | Abschlußdatum der Recherche | Prüfer |
|---|---|---|
| DEN HAAG | 20.März 1998 | Hoornaert, W |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)